# EUROPEAN PATENT APPLICATION

(11) **EP 4 604 686 A1**
(43) Date of publication of application: **20.08.2025**
(21) Application number: 24158324.4
(22) Date of filing: 19.02.2024
(51) Int. Cl.: H05K 9/00

(54) **EMC HOUSING FOR ELECTRICAL COMPONENTS**

(71) Applicant: Aptiv Technologies AG, 8200 Schaffhausen (CH)
(72) Inventor: BARUS, Lukasz, 8200 Schaffhausen (CH); SWIERCZ, Karol, 8200 Schaffhausen (CH); KUPCZYK, Pawel, 8200 Schaffhausen (CH)
(74) Representative: Bardehle Pagenberg Partnerschaft mbB Patentanwälte Rechtsanwälte

(57) **Abstract**

EMC housing 1 for electrical components 40, 42, 44, comprising a first electrically conducting housing part 10; a second electrically conducting housing part 20, wherein the first housing part 10 and the second housing part 20 are attached to each other at a parting line 2 of the EMC housing 1; and a retainer 30 arranged within the housing 1, wherein the retainer 30 comprises a retainer frame 34 and an electrically conductive and compressible EMC foam 32 around the outer perimeter 38 of the retainer frame 34, wherein the EMC foam 32 covers the parting line 2 of the EMC housing 1.

## Description

### 1. Field of the invention

The present invention relates to a housing for electrical components, wherein the housing provides EMC (ElectroMagnetic Compatibility).

### 2. Technical background

Electromagnetic compatibility (EMC) is the ability of electrical equipment and systems to function acceptably in their electromagnetic environment, by limiting the unintentional generation, propagation and reception of electromagnetic energy which may cause unwanted effects such as electromagnetic interference (EMI) or even physical damage to operational equipment. The goal of EMC is the correct operation of different equipment in a common electromagnetic environment.

Usually housings that provide EMC properties consist of a metallic material that shields electromagnetic radiation and protects from electromagnetic interference. As an alternative, an EMC protected housing can be made of a non-metallic material that is coated with a metallic material for providing EMC properties.

Common housings for electronic components that comprises EMC comprise often very complex and expensive solutions for EMC protection. Particularly, the parting lines of housing need special attention and EMC measures. Commonly, a metal-to-metal contact, EMC springs, FIP gaskets, etc. are used at parting lines of EMC housings. Any unwanted apertures where housing parts matches but cannot be in direct touch all along the parting line should be avoided as they can provide slot antenna occurrence or other field leaks. Such apertures are more likely if the housing is prone to assembly errors due to its complexity.

Therefore, an EMC housing for electronic components should be provided that overcomes the above-mentioned problems, particularly that avoids field leaks and that is easy to assemble.

### 3. Summary of the invention

The above-mentioned objects are at least partially achieved by the subject-matter of the independent claim. Preferred embodiments are subject of the dependent claims, and the skilled person finds hints for other suitable aspects of the present invention through the overall disclosure of the present application.

The above mentioned problems are particularly solved by an EMC housing for electrical components, comprising a first electrically conducting housing part; a second electrically conducting housing part, wherein the first housing part and the second housing part are attached to each other at a parting line of the EMC housing; and a retainer arranged within the housing, wherein the retainer comprises a retainer frame and an electrically conductive and compressible EMC foam around the outer perimeter of the retainer frame, wherein the EMC foam covers the parting line of the EMC housing.

The EMC housing comprises at least two electrically conducting housing parts which shield electromagnetic fields and protect the housed electronics from outer radiation. Since the compressible EMC foam securely covers the parting line of the EMC housing any remaining openings or gaps between the first and second housing parts are closed. This provides a different approach in grounding and eliminating potential field leakage compared to the prior art. The EMC foam additionally provides a reliable electrically conductive connection between the first and second housing parts, so that both housing parts is on the same electrical level, for example ground level. Further, the compressible EMC foam compensates dimensional tolerances of the housing parts, particularly tolerances at the parting line. This improves the EMC property of the EMC housing. Further, since the EMC foam is part of a retainer it is secured and exactly positioned within the housing what minimizes any assembly issues. No additional or loose parts as EMC seals or EMC springs are needed and need to be assembled. This saves overall costs and labor time. Generally, the EMC foam can be used to ground as many elements as possible including the housing parts and other parts like covers, lids and PCB's, connectors, other electrical components. The EMC foam sticked to the retainer has the possibility to ground multiple parts all around the cross section in comparison to applying only individual EMC connections for example between cover and lid of a housing.

Preferably, the retainer at its outer perimeter comprises a flange for holding the EMC foam. The flange increases the surface at the perimeter of the retainer for holding the EMC foam of the necessary dimensions. Thus, the height of the EMC foam can be selected to be high enough to provide enough overlap to securely cover the parting line from the inside of the housing. This significantly improves EMC properties and reduces assembly errors.

Preferably the flange comprises substantially a T-shape. Thus, the flange extends to both sides of the perimeter of the retainer.

Preferably, the retainer has a substantially flat shape with a main plane, wherein the flange is arranged substantially perpendicular to the main plane.

Preferably, the flange comprises a rounded perimeter face. Thus, the EMC foam, that is attached to the flange, will have a rounded perimeter face as well, particularly if the EMC foam has a constant thickness. This rounded shape facilitates assembly, as it allows that the edges of the housing parts at the parting line can easily compress the EMC foam with increasing compression force during assembly. This reduces the risk of damaging the EMC foam during assembly. Further, the round shape of the perimeter face and the EMC foam allow the EMC foam to further contact electronic components and/or PCBs (Printed Circuit Boards) within the housing. Thus, such electronic components and/or PCBs can be grounded by the EMC foam as well.

Preferably, the EMC foam is glued to the outer perimeter of the retainer frame. Thus, the EMC foam is securely held in place for assembly.

Preferably, the EMC foam is formed in place (FIP) or applied in place (AIP) to the outer perimeter of the retainer frame. By FIP the EMC foam can be applied in liquid form in-situ to the retainer frame very effectively. Then the liquid cures and forms the EMC foam at the retainer frame. Alternatively, an already pre-formed strip of EMC foam can be applied in place (AIP) to the retainer frame for example by means of an adhesive.

Preferably, the retainer frame is electrically conductive. Therefore, electrical components or PCBs can be grounded by mounting to the retainer frame.

Preferably, the retainer frame substantially divides the EMC housing into two housing cavities.

Preferably, the retainer frame consists of die casted metal. Preferably, the retainer frame consists of die casted aluminum, zinc, or zinc alloys. In an alternative, the retainer may be fully made of a plastic material with only properly applied EMC foam as means for electrical connection between all needed components, particularly between the housing parts and optionally the PCB.

Preferably, the retainer further comprises mounting means for electrically conductive mounting of electronical components, particularly a PCB.

Preferably, the inner edges of the first and second housing parts at the parting line comprise chamfers for compressing the EMC foam during assembly. Thus, the housing parts can be easily fit together, while simultaneously compressing the EMC foam. Thereby, the chamfers increase the compression force for the EMC foam during the process of fitting the housing parts together.

Preferably, the first housing part and/or the second housing part comprise cooling fins at the outside thereof. Thus, the housing can be essentially closed to the inside to improve the EMC properties but allow heat dissipation at the outside thereof. Thus, the EMC housing can be used for high power electronics as well.

Preferably, the EMC foam further contacts electrical components and/or a PCB within the EMC housing. Thus, the electrically conductive EMC foam can also be used to ground electrical components and/or PCBs within the EMC housing.

### 4. Brief description of preferred embodiments

In the following, a preferred embodiment of the invention is disclosed by reference to the accompanying figures.
- Fig. 1:: shows a three-dimensional partial sectional view of an EMC housing according to an embodiment of the present invention;
- Fig. 2:: shows a three-dimensional explosion view of the main components of the EMC housing of Fig. 1;
- Fig. 3:: shows a three-dimensional view of a retainer with an EMC foam of the EMC housing of Fig. 1; and
- Fig. 4:: shows a vertical sectional view of the EMC housing of Fig. 1 in the area of the parting line.

### 5. Detailed description of preferred embodiments

In the subsequent passages, a preferred embodiment of the invention is described with reference to the accompanying figures in more detail. It is noted that further embodiments are certainly possible, and the below explanations are provided by way of example only, without limitation. Throughout the present figures and specification, the same reference numerals refer to the same elements. The figures may not be to scale, and the relative size, proportions, and depiction of elements in the figures may be exaggerated for clarity, illustration, and convenience.

It is noted that when features, aspects, and/or embodiments are described herein by the term "substantially", manufacturing tolerances must be taken into consideration. In this manner, minor deviations during any kind of manufacturing, assembling or the like may pertain. Further, manufacturing tolerances, aging effects, or other minor defects or the like may pertain. These are all encompassed by the term "substantially". Although not always explicitly expressed by using the term "substantially", it is understood that the elements, parts, units, shapes, and / or the like described herein may nevertheless comprise such manufacturing tolerances.

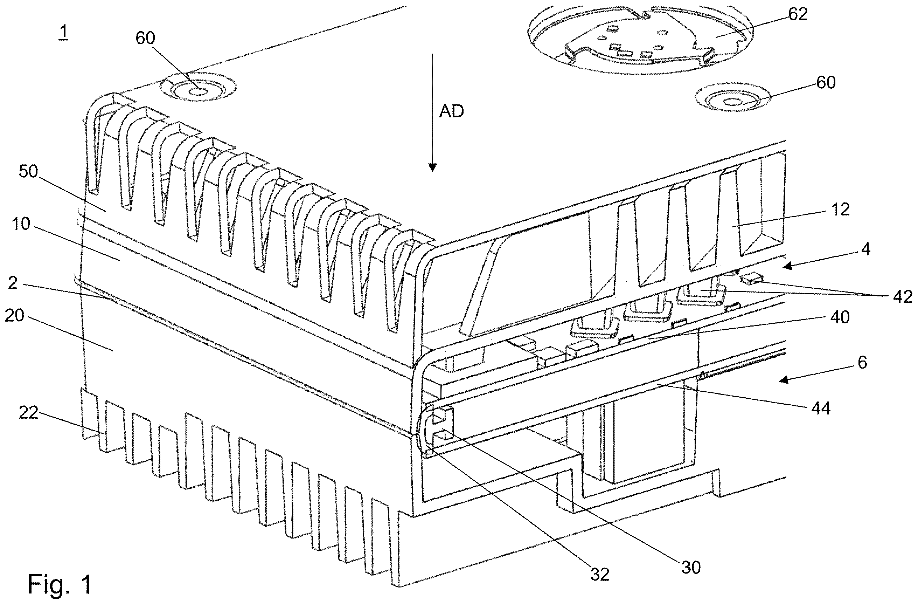

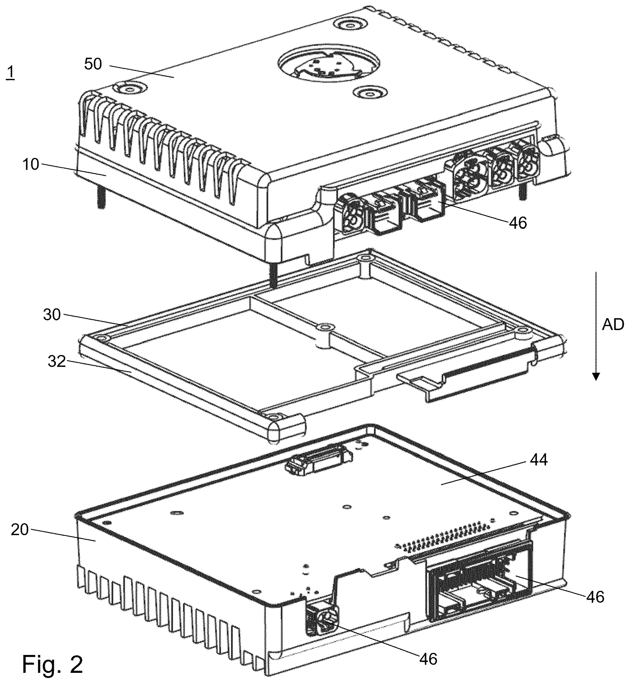

Figs 1 and 2 show an EMC housing 1 for electrical components. The EMC housing 1 provides EMC properties for shielding electronic components 40, 42, 44 from outside electromagnetic fields or electromagnetic radiation or electromagnetic waves. Therefore, the EMC housing 1 comprises electrically conducting housing parts 10, 20 that enclose the internal electronic components 42 that are preferably arranged on two PCBs 40, 44. In the present embodiment the EMC housing comprises a first electrically conducting housing part 10 and a second electrically conducting housing part 20, which can be attached to each other at a parting line 2 of the EMC housing 1. Thereby, the first housing part 10 is hollow and provides a first housing cavity 4 and the second housing part 20 is also hollow and provides a second housing cavity 6. The EMC housing 1 may comprise additional electrically conducting housing parts. The first and second housing parts 10, 20 are preferably made of die cast aluminum or other metal or alloy or may be made of sheet metal. Both housing parts may differ in technology in same application. Alternatively, the housing parts 10, 20 may be made of an electrically non-conducting plastic material that is covered or coated by a layer of electrically conducting metal in the inside or made of a woven electrically conducting means that is over-molded by a plastic material.

The EMC housing 1 further comprises a retainer 30, which is arranged within the EMC housing 1. The retainer 30 on the one hand serves for mounting or separating electrical components 42 or one or two PCBs 40, 44 with electrical components 42 within the EMC housing 1. On the other hand, the retainer 30 serves for EMC sealing the parting line 2 between the first and second housing parts 10, 20. To this end the retainer comprises a retainer frame 34 as mechanical structure and an electrically conductive and compressible EMC foam 32 around the outer perimeter 38 of the retainer frame 34. The retainer frame 34 substantially divides the EMC housing 1 into the two housing cavities 4, 6.

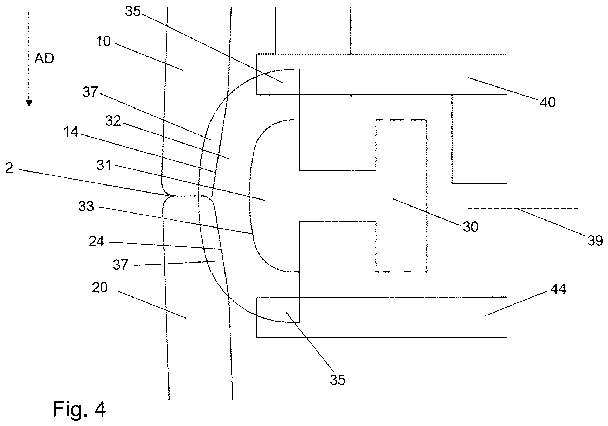

The retainer 30 is arranged within the EMC housing 1 such that the EMC foam 32 covers the parting line 2 of the EMC housing 1 from the inside. In assembled condition of the EMC housing 1 the EMC foam 32 is compressed by the edges of the first and second housing parts 10, 20 at the parting line 2. Thus, the EMC foam 32 EMC seals the parting line 2 from the inside and provides a conductive bridge between the first housing part 10 and the second housing part 20. In addition, the EMC foam 32 may also contact electronic components or PCBs 40, 44 as shown in Fig. 4. Thereby, the EMC foam 32 also grounds the electronic components or PCBs 40, 44. The retainer 30 with the EMC foam 32 also fits in applications with only one PCB 40 or 44.

The EMC housing 1 may further comprise cooling fins 12, 22 at the outside of the fist housing part 10 and second housing part 20 to dissipate heat produced by the electronic components 42 within the EMC housing 1. The cooling fins 12, 22 are particularly favorable since the EMC housing 1 should be substantially closed around the electronic components 42 to improve the EMC properties. The EMC housing 1 may further comprise an electric fan (not shown) for providing an air flow around the cooling fins 12, 22. Further, the EMC housing 1 may comprise a hood 50 on the outside of the first housing part 10, wherein the hood 50 encloses the electric fan and the cooling fins 12. The hood 50 may comprise a fan aperture or fan mounting 62 for mounting the fan and mounting means 60 for mounting the EMC housing 1. As for the first housing part 10 also the second housing part 20 can comprise a hood (not shown) and/or active cooling by an electric fan. The electric fan for the second housing part 20 provides an air flow around the cooling fins 22. One of or both housing parts 10, 20 of the EMC housing 1 can be actively or passively cooled, depending on the cooling strategy.

As shown in Fig. 2 the EMC housing 1 further comprises electrical connectors 46 at the outside of the EMC housing 1 for electrically connecting the electronics 40, 42, 44 within the EMC housing 1 with other electronics or electrical power. The electrical connectors 40, 42, 44 can be arranged in one of or in both housing parts 10, 20.

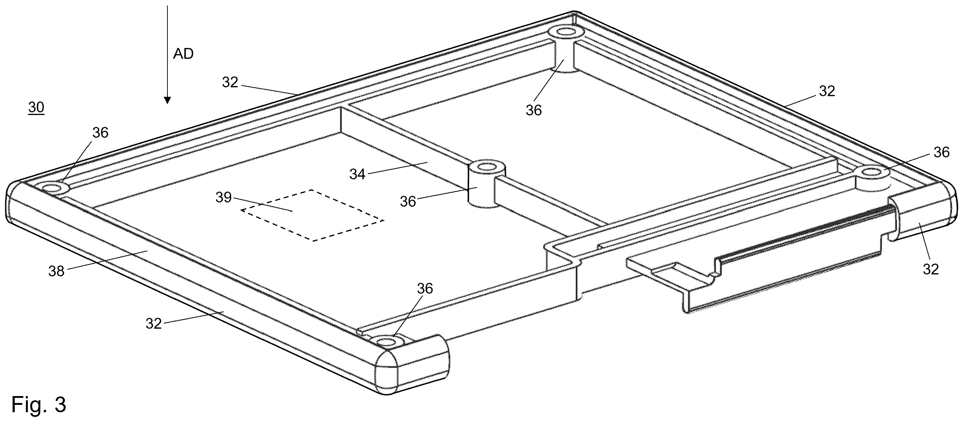

Fig. 3 and 4 show further details of the retainer 30. The retainer 30 has a substantially flat shape with a main plane 39. The main plane 39 is preferably substantially perpendicular to the assembly direction AD of the first and second housing parts 10, 20. The retainer frame 34 can be electrically conductive. In this case it can be made of die cast aluminum or other metal. It can also made of a plastic material if whole conductivity is restrained to the EMC foam 32 itself. The retainer 30 further comprises mounting means 36 for electrically conductive or non-conductive mounting of electronical components, particularly the PCBs 40, 44.

As shown in Fig. 4 the retainer 30 comprises at its outer perimeter a flange 31 for holding the EMC foam 32. Preferably, the flange 31 has a substantially T-shape. The flange 31 is further substantially perpendicular to the main plane 39 of the retainer 30. For a better compression of the EMC foam 32 and an easier assembly the flange 31 comprises a rounded perimeter face 33. Thus, also the outer face of the EMC foam 32 is rounded. Alternatively, the outer face of the EMC foam 32 may be triangle shaped or have an angularly broken flange or any other shape that eases tolerances and production methods and facilitates assembly of the EMC housing 1.

Fig. 4 shows schematically the overlapping areas 37 of the EMC foam 32 that are compressed by the edges of the housing parts 10, 20 during assembly. The mounting and compression are facilitated by chamfers 14, 24 the inner edges of the first and second housing parts 10, 20 at the parting line 2. Thus, the compression increases when the first and second housing halve 10, 20 are fit together in assembly direction AD. The compression of the EMC foam 32 provides a perfect EMC seal for the parting line 2 and compensates any manufacturing and assembly tolerances of the housing parts 10, 20 in the area of the parting line 2.

Preferably, the EMC foam 32 is a pre-shaped strip of electrically conducting foam that is applied in place (AIP) to the outer perimeter 38 of the retainer frame 34. Preferably, the EMC foam 32 is glued to the outer perimeter 38 of the retainer frame 34, particularly glued to the outer perimeter face 33 of the flange 31. As an alternative, the EMC foam 32 is directly molded by the form in place method (FIP) to the outer perimeter 38 of the retainer frame 34. The AIP and FIP methods can be performed by a NC controlled robot or machine. Thus, the AIP and FIP methods reduce manual assembly effort and provides a very good bonding of the EMC foam 32 to the flange 31.

As shown in Fig. 4 the EMC foam 32 further contacts electrical components 42 and/or a PCB 40, 44 within the EMC housing 1. Thereby, the overlapping areas 35 of the EMC foam 32 are compressed in assembly direction AD such that the EMC foam 32 presses against the underside of PCB 40 and the upper side of PCB 44. Thus, the PCBs 40 and 44 can also be electrically grounded by the EMC foam 32 if necessary. This further allows to separate the first housing cavity 4 and the second housing cavity 6 in terms of EMC from each other, if necessary.

The EMC foam 32 is preferably made of polyolefin that is metallized by copper or nickel. Further, the EMC foam 32 can be made of an electrically conductive PE or PUR foam or can consist of any foam like polymer with any means incorporated that are electrically conductive.

### List of reference signs

- 1: EMC housing
- 2: parting line
- 4: first housing cavity
- 6: second housing cavity
- 10: first housing part
- 12: cooling fins
- 14: chamfer
- 20: second housing part
- 22: cooling fins
- 24: chamfer
- 30: retainer
- 31: flange
- 32: EMC foam
- 33: rounded perimeter face
- 34: retainer frame
- 35: overlapping areas
- 36: mounting means
- 37: overlapping areas
- 38: outer perimeter
- 39: main plane
- 40: first PCB
- 42: electronic components
- 44: second PCB
- 46: electrical connectors
- 50: hood
- 60: mounting means
- 62: fan aperture/mounting

## Claims

1. EMC housing (1) for electrical components (40, 42, 44), comprising:
a. a first electrically conducting housing part (10);
b. a second electrically conducting housing part (20), wherein the first housing part (10) and the second housing part (20) are attached to each other at a parting line (2) of the EMC housing (1); and
c. a retainer (30) arranged within the housing (1), wherein the retainer (30) comprises a retainer frame (34) and an electrically conductive and compressible EMC foam (32) around the outer perimeter (38) of the retainer frame (34), wherein the EMC foam (32) covers the parting line (2) of the EMC housing (1).

2. EMC housing according to claim 1, wherein the retainer (30) at its outer perimeter (38) comprises a flange (31) for holding the EMC foam (32).

3. EMC housing according to claim 2, wherein the flange (31) comprises substantially a T-shape.

4. EMC housing according to one of the claims 2 or 3, wherein the retainer (30) has a substantially flat shape with a main plane (33), wherein the flange (31) is arranged substantially perpendicular to the main plane (33).

5. EMC housing according to one of the claims 2 to 4, wherein the flange (31) comprises a rounded perimeter face (33).

6. EMC housing according to one of the claims 1 to 5, wherein the EMC foam (32) is glued to the outer perimeter (38) of the retainer frame (34).

7. EMC housing according to one of the claims 1 to 6, wherein the EMC foam (32) is formed in place (FIP) or applied in place (AIP) to the outer perimeter (38) of the retainer frame (34).

8. EMC housing according to one of the claims 1 to 7, wherein the retainer frame (34) is electrically conductive.

9. EMC housing according to one of the claims 1 to 8, wherein the retainer frame (34) substantially divides the EMC housing (1) into two housing cavities (4, 6).

10. EMC housing according to one of the claims 1 to 9, wherein the retainer frame (34) consists of die casted metal.

11. EMC housing according to one of the claims 1 to 10, wherein the retainer (30) further comprises mounting means (36) for electrically conductive mounting of electronical components (40, 42, 44), particularly a PCB (40, 44).

12. EMC housing according to one of the claims 1 to 11, wherein the inner edges of the first and second housing parts (10, 20) at the parting line (2) comprise chamfers (14, 24) for compressing the EMC foam (32) during assembly.

13. EMC housing according to one of the claims 1 to 12, wherein the first housing part (10) and/or the second housing part (20) comprise cooling fins (12, 22) at the outside thereof.

14. EMC housing according to one of the claims 1 to 13, wherein the EMC foam (32) further contacts electrical components (42) and/or a PCB (40, 44) within the EMC housing (1).
